# EUROPEAN PATENT SPECIFICATION

(11) **EP 2 582 037 B1**
(45) Date of publication and mention of the grant of the patent: **20.12.2017**
(21) Application number: 11008245.0
(22) Date of filing: 12.10.2011
(51) Int. Cl.: H03F 1/02, H03G 5/22, H02J 7/34, H03G 5/04, H03F 3/181

(54) **Device and method for reproducing an audio signal**
Vorrichtung und Verfahren zur Wiedergabe eines Audiosignals
Dispositif et procédé pour la reproduction d'un signal audio

(43) Date of publication of application: 17.04.2013
(73) Proprietor: Harman Becker Automotive Systems GmbH, 76307 Karlsbad (DE)
(72) Inventor: Münch, Tobias, 75334 Straubenhardt (DE); Schmauderer, Philipp, 75339 Höfen (DE); Benz, Christoph, 77797 Ohlsbach (DE); Körner, Andreas, 76337 Waldbronn (DE)
(74) Representative: Grünecker Patent- und Rechtsanwälte PartG mbB

(56) References cited:
- EP-A1- 1 024 577
- FR-A1- 2 707 131
- JP-A- 2009 171 647
- US-A1- 2002 044 637

## Description

The present invention concerns a device and a method for reproducing an audio signal.

So called infotainment systems are known for motor vehicles. An infotainment system is configured to reproduce an audio signal. In EP 1 024 577 A1 a power system is described that comprises a secondary battery and wherein the supply of DC power is not stopped at a time of charging a main battery after the secondary battery is completely discharged. Depending on the charging procedure one of the main battery and the secondary battery is charged whereas the other one supply power to an amplifier. In JP 09 223938 a device for reproducing an audio signal is described that attenuates low frequency components if an output voltage of a battery falls below a predetermined threshold. In JP2009171647 A an electric vehicle is described that is configured to control a reduction in charge state based on a determined distance to a certain destination.

The object of the invention is to improve a device for reproducing an audio signal to the greatest extent possible.

This object is attained by a device with the features of independent claim 1. Advantageous developments are the subject matter of dependent claims, and are contained in the description.

Accordingly, a device is provided for reproducing an audio signal. The device has a first interface for connection to an energy storage device. The energy storage device comprises, for example, a battery or a fuel cell or preferably a rechargeable battery. The first interface preferable has connections for energy supply and/or signal connections.

The device has a second interface for connection to a loudspeaker. The second interface is preferably a preamplifier output and/or a final amplifier output for outputting the audio signal. For example, the loudspeaker is connected to the second interface by means of a cable. It is likewise possible for the loudspeaker to be connected to the second interface through an amplifier, such as a subwoofer.

The device has an amplifier, which is connected to the second interface and is designed to amplify the audio signal. The amplifier is, for example, a preamplifier or a power amplifier. The amplifier of the device is connectable to the energy storage device for operation.

The device has a control device, which is connected to the first interface and to the amplifier. The control device preferably has a computing unit, for example a microcontroller and/or a signal processor and/or a CPU for executing a control program, wherein the control program provides control functions of the control device.

The control device is configured to operate a normal mode and an energy saving mode. In energy saving mode, a power consumption of electrical energy from the energy storage device for reproduction of the audio signal is reduced as compared to the normal mode.

The control device is configured, in the energy saving mode, to reduce the bass frequency component of a frequency spectrum of the audio signal and to output the audio signal through the second interface with reduced bass frequency component.

The control device is designed to determine a charge state of the energy storage device. For example, a digital or analog charge state signal is transmitted from the energy storage device to the control device for determining the charge state.

The control device is designed to control the reduction in the bass frequency component based on a decrease in the charge state of the energy storage device. The control device is designed to reduce the bass frequency component by means of a function when there is a decrease in the charge state.

In addition, the control device is connectable to a database with stored audio files, an energy value is stored for each of said audio files, wherein the energy value is based on the bass frequency component of a frequency spectrum of the respective one of said audio files,
the control device is configured to determine an energy threshold based on the charge state of the energy storage device,
the control device is configured, for the purpose of controlling the bass frequency component, to ascertain one of said audio files to be output based on the associated energy value of the audio file and based on the energy threshold, and to output the one of said audio files as the audio signal.

For example, the bass frequency component is reduced proportionately or by means of an LUT (Look Up Table).

Moreover, the control device may be configured to determine a current position and a route to a destination with a distance to the destination and to control the reduction in the bass frequency component (B) based on the charge state (C) and the determined distance to the destination.

The invention has the additional object of specifying a method as greatly improved as possible for reproducing an audio signal.

This object is attained by the method with the features of independent claim 6. Advantageous developments are contained in the description.

Accordingly, a method is provided for controlling reproduction of an audio signal. The audio signal is reproduced by a device that is operated by means of an energy storage device.

In the method, a normal mode is deactivated and an energy saving mode is activated, wherein in energy saving mode a power consumption from the energy storage device for reproduction of the audio signal is reduced as compared to the normal mode. In the energy saving mode, a bass frequency component of a frequency spectrum of the audio signal is reduced and the audio signal is output with reduced bass frequency component.

A charge state of the energy storage device is determined during the energy saving mode and a current position and a route to a destination with a distance to the destination may be determined.

The reduction in the bass frequency component is controlled based on a decrease in the charge state of the energy storage device and, optionally, the determined distance.

The inventive method, further, comprise storing in a database audio files and an energy value for each of said audio files, wherein the energy value is based on the bass frequency component of a frequency spectrum of the respective one of said audio files, determining an energy threshold based on the charge state of the energy storage device; controlling the bass frequency component, to ascertain one of said audio files to be output based on the associated energy value of the one of said audio files and based on the energy threshold; and outputting the one of said audio files as the audio signal.

The developments described below relate to the device as well as to the method for reproducing an audio signal.

According to the invention, provision is made for the control device to be connected to a database with stored audio files. Metadata associated with the audio files are stored in the database. Such metadata are, for instance, ID3 tags and other data as applicable.

An energy value for each of the stored audio files is stored as an item of the metadata. The energy value is based on the bass frequency component of a frequency spectrum of the applicable audio file. For instance, the energy value is determined using a transformation in the frequency range and stored.

The control device is configured to determine an energy threshold based on the charge state of the energy storage device. In a further development, the control device is configured to evaluate at least one additional input quantity for determining the energy threshold. For example, the additional input quantity is dependent on other electrical devices - such as an electric motor or a solar cell - that affect the charge state of the energy storage device. A distance to a destination or a remaining travel time of an electric vehicle is used for determining the energy threshold.

For controlling the bass frequency component, the control device is configured to determine an audio file to be output based on the energy threshold and based on the associated energy value of the audio file from the database, and to output the audio file as the audio signal.

According to another development, the control device is configured to use a digital or analog filter for filtering the audio signal to be output in order to reduce the bass frequency component. Such a filter is, for example, an analog or digital high-pass filter or band-pass filter. Advantageously, the filtering by the filter is combined with the above-described selection using the energy threshold.

In an advantageous embodiment, the control device is configured to determine a threshold frequency of the filter based on the charge state of the energy storage device. Preferably, the threshold frequency of the filter is increased for low frequencies of the audio signal as the charge state decreases.

The control device is configured to determine a current position and a route to a destination with a distance to the destination. The distance to the destination preferably is determined by GPS (Global Positioning System). The distance between the current position and the destination is advantageously determined thereby. The necessary charge state for this range is determined on the basis of the distance. For example, a difference is ascertained between the current charge state and the necessary charge state for reaching the destination, and the reduction in the bass frequency component is controlled by means of the ascertained difference.

Therefore, the control device is configured to control the reduction in the bass frequency component based on the current charge state and the distance to the destination.

In another advantageous embodiment, the control device is configured to activate the energy saving mode based on an input through an input unit.

The variant embodiments described above are especially advantageous, both individually and in combination. All embodiments may be combined with one another. Some possible combinations are explained in the description of the drawings. However, these possibilities of combinations of the variant embodiment introduced there are not exhaustive.

The invention is explained in detail below through exemplary embodiments with reference to drawings.

The figures show
Fig. 1 a schematic diagram with curves of equal loudness,
Fig. 2 a schematic block diagram,
Fig. 3 a schematic diagram for an example not being part of the invention,
Fig. 4 another schematic diagram for another example not being part of the invention,
Fig. 5 a schematic representation of a device for reproducing an audio signal,
Fig. 5a a schematic embodiment of a control device not being part of the invention,
Fig. 5b an embodiment of a control device, and
Fig. 6 an input unit.

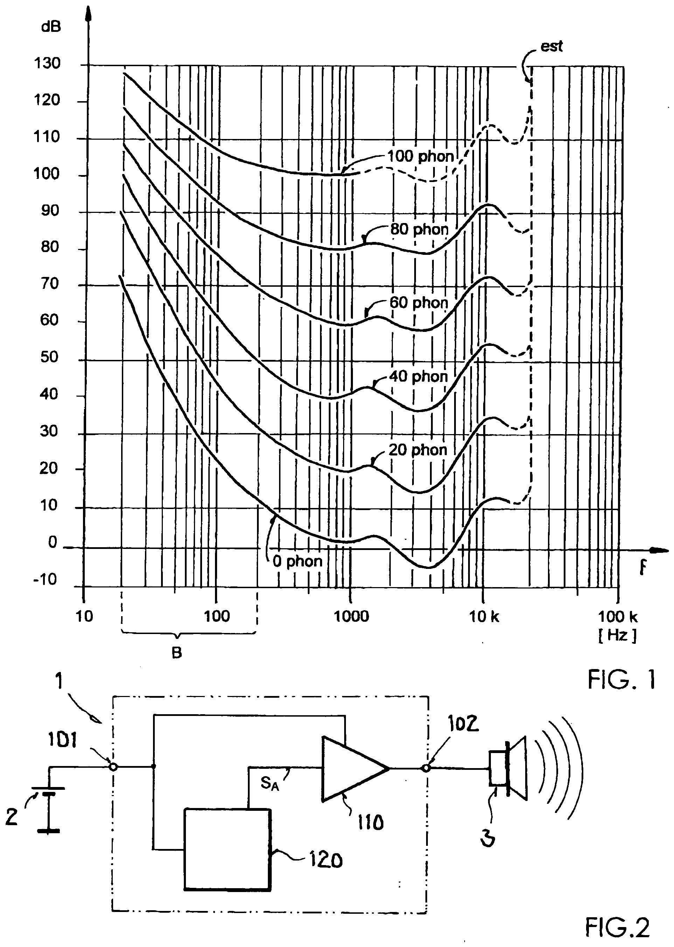

Shown schematically in Fig. 1 is a diagram with curves of equal loudness - as per ISO standard 226(2003). The diagram shows that the perceived loudness is strongly frequency-dependent. This frequency dependence itself is in turn sound-pressure-dependent, which means that different frequency dependencies exist for different levels. For this reason, the frequency spectrum X(f_{SA}) of the sound must be determined if statements are to be made about the perception of a sound event. Furthermore, a time behavior of a sound event as well as a sound event that extends over multiple frequency groups (overtones) also have an effect on the perception of loudness. In order to be able to quantify the perceived loudness of which Fig. 1 shows a graph of the loudness level (with phon as the unit of measure) as a function of frequency. For example, it is known to use an A-filter for evaluation, wherein the frequency filter used in each case can be appended to the dB value (dB = decibels) in parentheses, as for example 20 dB(A). The curves have regions est extrapolated by calculation.

The curves with equal perceived loudness level (e.g. 20 phon) represented in Fig. 1 show that the sound pressure dB with a bass frequency component B - also called bass portion B - rises sharply with decreasing frequency below approximately 200 Hz. In order to reproduce a sound event in the bass frequency component B, it is thus necessary to generate a significantly higher sound pressure dB as compared to a frequency of 1 kHz. Thus, a correspondingly higher electrical power is required to generate the high sound pressure dB of the bass portion B, when the sound event is reproduced with a loudspeaker. If, for example, a sound event with a bandwidth of 20 Hz to 2 kHz is to be reproduced with a perceived loudness level of 20 phon, then a sound pressure of approximately 20 dB must be generated for the frequency of 2 kHz. In contrast, a sound pressure of 90 dB must be generated for the frequency of 20 Hz. Consequently, more electrical power must be applied for the bass portion B in the low-frequency range in order to produce the same perception of loudness in the human ear as at mid-range or high audio frequencies.

Furthermore, the required electrical power depends on an efficiency and/or a directional characteristic of a loudspeaker. For example, tweeters can have a somewhat higher efficiency than woofers. The higher the frequency, the more the sound is directed and the power theoretically increases at the listening point. The lower the frequency becomes, the more omnidirectional the sound becomes, requiring more power for the same sound pressure at the listening point. Furthermore, the radiated power can decrease when the wavelength of the frequency is smaller than the membrane radius. Moreover, the acoustical space can influence the sound pressure in a frequency-dependent manner. For example, a pressure chamber effect occurs in a motor vehicle. When all physical effects that act are taken into account, the majority of the electrical power is required for the bass portion B at the same perceived loudness.

Fig. 2 schematically shows a device 1 for reproducing an audio signal S_{A}. The device 1 is, for example, an infotainment system of a motor vehicle or a portable player for the audio signal S_{A}. The device 1 has a first interface 101 for connection to a rechargeable battery 2 as electrical storage device. The device 1 also has a second interface 102 for connection to a loudspeaker 3. For example, the loudspeaker 3 is connected directly to a connection of the second interface 2 through cables. It is also possible to connect the loudspeaker 3 to the second interface 102 through a subwoofer amplifier (not shown). The device 1 of the exemplary embodiment from Fig. 1 has an amplifier 110 that is connected to the second interface 102 and is designed to amplify the audio signal S_{A}. For operation, the amplifier 110 is connected to the rechargeable battery 2 through the first interface 101. In addition, the device 1 from Fig. 1 has a control device 120, which is connected to the first interface 101 and to the amplifier 110.

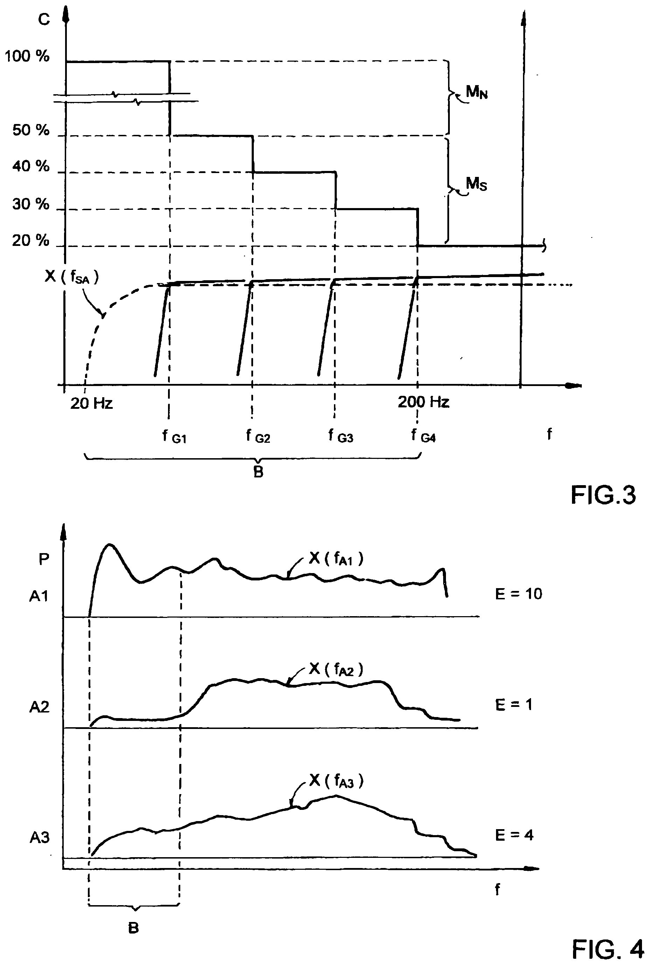

An example not being part of the invention is explained in detail with reference to the diagram in Fig. 3. A charge state C of the rechargeable battery 2 is shown at 20%, 30%, 40%, 50% and 100% charge. In the exemplary embodiment from Fig. 3, the charge state C with more than 50% is associated with a normal mode M_{N} and a charge state C with less than 50% is associated with an energy saving mode Mₛ of the device 1. Also shown by way of example is the frequency spectrum X(f_{SA}) of the audio signal S_{A} with respect to the frequency f. The control device 120 from Fig. 2 is designed to reduce a power consumption from the rechargeable battery 2 for reproduction of the audio signal S_{A} in the energy saving mode Mₛ as compared to the normal mode M_{N}. In the exemplary embodiment from Fig. 3 the bass portion B of the audio signal S_{A} is reduced in energy saving mode Mₛ by the audio signal S_{A} being high-pass filtered. In Fig. 3, the frequency response of the filtering is shown for different threshold frequencies f_{G1}, f_{G2}, f_{G3}, f_{G4}. The audio signal S_{A} is output with reduced bass portion B after the high-pass filtering.

The control device 120 in Fig. 2 is configured to determine the charge state C. For example, an electrical quantity of the rechargeable battery 2, such as the rechargeable battery voltage or its behavior over time, is measured for this purpose. The control device 120 is configured to control the reduction in the bass portion B based on a decrease in the charge state C of the rechargeable battery 2. In the exemplary embodiment from Fig. 3, the reduction in the bass portion B is accomplished by filtering. In the exemplary embodiment from Fig. 3 a digital and/or analog high-pass filtering is performed by the control device 120. In this embodiment, the control device 120 has a controllable filter function. In another embodiment the high-pass filter is activated or deactivated as a function of the charge state C. For instance, the high-pass filter is deactivated at a charge state C above 50%.

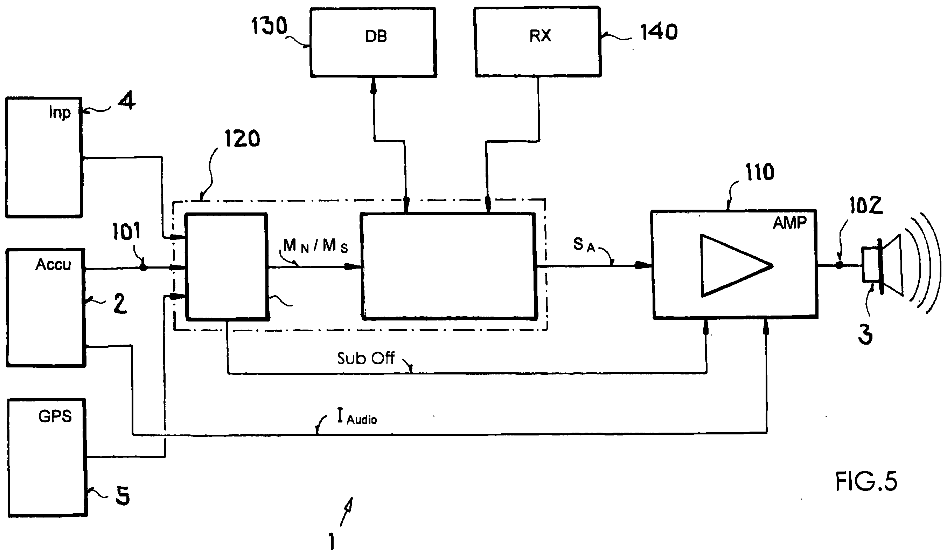

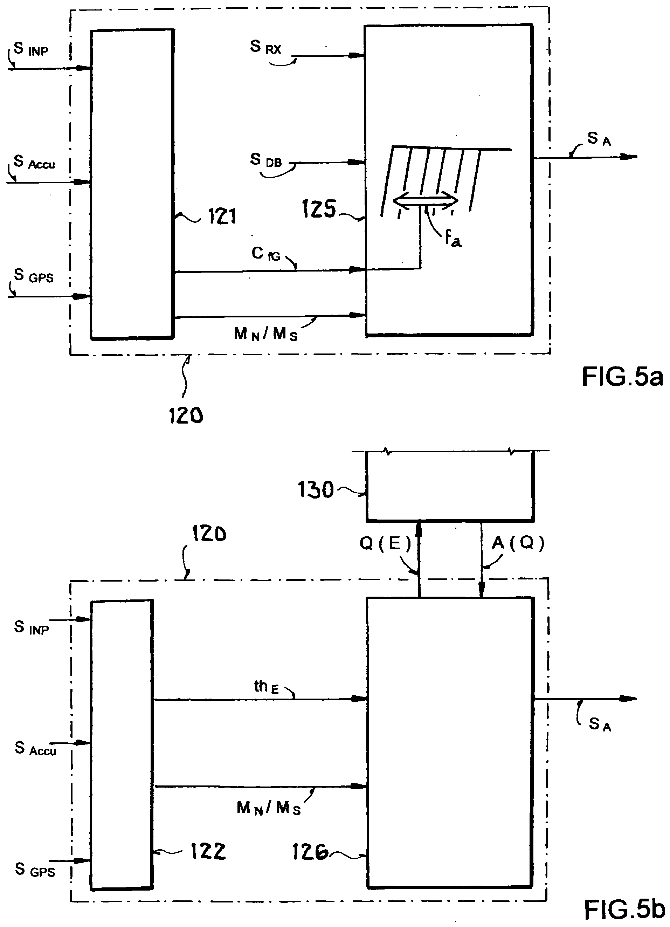

In the example from Fig. 3, the high-pass filtering can be controlled by the control device 120 in that a cut-off frequency f_{G1}, f_{G2}, f_{G3}, f_{G4} of the high-pass filtering can be altered. In the exemplary embodiment from Fig. 3 the high-pass filtering is deactivated in the normal mode M_{N} at a charge state C above 50%. A first cut-off frequency value f_{G1} is associated with a charge state C between 40% and 50%. A second cut-off frequency value f_{G2} is associated with a charge state C between 30% and 40%. A third cut-off frequency value f_{G3} is associated with a charge state C between 20% and 30%. In contrast, a fourth cut-off frequency value f_{G4} - for example 200 Hz - is associated with a charge state C below 20%. The cut-off frequencies f_{G1}, f_{G2}, f_{G3}, f_{G4} are controlled as a function of the charge state C by means of a step function in the exemplary embodiment from Fig. 3. Alternatively, a proportional dependency may be provided. It is likewise possible to deactivate a subwoofer amplifier (not shown in Fig. 3) in energy saving mode Mₛ. In addition to the charge state C, additional input quantities can be analyzed for controlling the reduction, as is explained in detail in the description of Fig. 5.

Another example not being part of the invention is explained using the graph in Fig. 4. The control device 120 has a connection to a database (130 in Fig. 5, not shown in Fig. 4) for this purpose. The database has audio files A₁, A₂, A₃ and metadata associated with each audio file A₁, A₂, A₃. In this design, an energy value E is included in the metadata. The diagram from Fig. 4 schematically shows one frequency spectrum X(f_{A1}), X(f_{A2}), X(f_{A3}) for each audio file A₁, A₂, A₃ and an associated energy value E stored in the database. Thus, the energy value associated with the first data file A₁ is E=10, the energy value associated with the second audio file A₂ is E=1, and the energy value associated with the third audio file A₃ is E=4. The applicable energy value E is determined on the basis of a power P in the bass portion B of the spectrum X(f_{A1}), X(f_{A2}), X(f_{A3}). To this end, the power P is acquired as the average over the entire length of the audio file A₁, A₂, A₃, for example.

In Fig. 5, a device 1 for reproducing an audio signal S_{A} is explained in detail. The device 1 has a control unit 120, which is connected through a first interface 101 to a rechargeable battery 2, Accu. In addition, the device has an amplifier 110, AMP, which can be connected to a loudspeaker 3 through a second interface 102. The amplifier 110 can have multiple amplifier units, and is supplied with the current I_{Audio} from the rechargeable battery 2. In the exemplary embodiment from Fig. 5, a subwoofer amplifier unit can additionally be activated and deactivated by means of the control signal SubOff. The amplifier 110 has the function of outputting the amplified audio signal S_{A} to the loudspeaker 3.

The device 1 has a control unit 120 for outputting the audio signal S_{A} to the amplifier 110. The control device 120 is configured to operate a normal mode M_{N} and an energy saving mode M_{S}. For this purpose, the control device 120 is configured to generate control signals associated with the normal mode M_{N} and the energy saving mode M_{S}. The activation and deactivation of normal mode M_{N} and energy saving mode M_{S} is accomplished by means of input signals, such as an input by a user by means of an input unit 4 and/or a monitoring signal of an energy storage device 2 - such as an output voltage of a rechargeable battery - and/or a position-dependent signal from a navigation unit - such as a distance to a destination of a route. The energy saving mode M_{S} is activated and deactivated as a function of the said input signals, wherein in energy saving mode M_{S} an power consumption from the energy storage device 2 for reproduction of the audio signal S_{A} is reduced as compared to normal mode M_{N}.

By means of the example from Fig. 5 that is not part of the invention, the music played in an electric motor vehicle is meant to be manipulated as a function of the charge state C of the rechargeable lithium-ion battery in such a manner that low-power titles can be played as needed or the music played can be altered/rid of high-power low frequencies by filtering. In this way, the energy saved in the rechargeable battery 2 by the device 1 can benefit the range of the motor vehicle. In addition, a loudness adjustment can also take place.

Music systems in electric motor vehicles consume electrical energy. If the energy should rather be used for the range of the electric vehicle instead, the option exists of manually turning off the music system entirely. But if vehicle occupants do not wish to forego the enjoyment of music altogether, the energy that is available must be distributed intelligently. When the rechargeable battery has low charge, only low-power music is output at the loudspeaker 3 by the device 1. The low-power music is obtained by categorizing the music pieces and/or by filtering out high-power portions of the frequency spectrum. This has a direct effect on the acoustic power and, at the same time, on the electrical power consumption.

The electrical power consumption of a music system in an electric vehicle depends largely on the playing loudness and the frequency spectrum X(f_{SA}) of the audio signal S_{A} that is output. The acoustic power emitted through the loudspeaker 3 is directly related to the electrical power. Since the range of an electric vehicle depends on the charge state C of the rechargeable battery 2, the range is increased when the music system, as an energy consumer, conserves current I_{Audio} for amplification of the audio signal S_{A} to be output.

In the example from Fig. 5, the control unit 120 is connected to multiple audio signal sources 130, 140. A database 130, DB connected through an interface or a network permits the selection and output of an audio file as the audio signal S_{A}. In contrast, a receiving device 140, RX is designed for audio reception, in particular via radio. The receiving device 140, RX has, for example, a UHF receiver or a DAB receiver or the like.

Fig. 5a shows an example of a control device 120 with an analysis unit 121 and a digital and/or analog filter 125 not being part of the invention. Electrical energy can be taken from the audio signal S_{A} by means of filtering by the filter 125. The filter 125 preferably has a high-pass filter or a band-pass filter, which acts on the audio signal S_{A}. The audio signal S_{A} here comes from any desired source, such as a receiving device 140, a CD player or an MP3 player. In the exemplary embodiment from Fig. 5a, a cut-off frequency f_{G} of the filter 125 is adjusted as a function of a charge state C of the rechargeable battery 2 and a remaining travel distance determined by the navigation unit 5, wherein the rechargeable battery 2 and the navigation unit 5 are shown schematically in Fig. 5.

The analysis unit 121 is designed to analyze the signal S_{INP} from the input unit 4 and/or the signal S_{Accu} from the rechargeable battery 2 and/or the signal S_{GPS} from the navigation unit 5. In the exemplary embodiment from Fig. 5a, the signal S_{INP} from the input unit 4 is generated from input entered by the user on a touch screen. The signal S_{Accu} from the rechargeable battery 2 is generated on the basis of, for instance, a voltage or a current budget of the rechargeable battery 2 and is dependent upon the charge state C of the rechargeable battery 2. The signal S_{GPS} from the navigation unit 5 is determined as a function of a distance to be traveled that has been determined by the navigation unit 5.

Using the input signals S_{INP}, S_{Accu}, S_{GPS} the analysis unit 121 generates a signal M_{N}/M_{S} for controlling an activation or deactivation of a normal mode M_{N} and an energy saving mode M_{S}. Furthermore, in the exemplary embodiment from Fig. 5a, a control signal C_{fG} is output in order to adjust the cut-off frequency f_{G} of the filter 125, wherein the filter 125 filters the bass portion B out of the input signal S_{DB} (from the database 130) or out of the input signal S_{RX} (from the receiving unit 140). For example, the control can take place in accordance with the diagram for the exemplary embodiment in Fig. 3 by means of an LUT (Look Up Table). The lower the charge state C of the rechargeable battery 2 is, the higher the cut-off frequency f_{G} will be set, since low frequencies in a bass portion B of the spectrum X(f_{SA}) consume more electrical energy. In addition, provision is made in the exemplary embodiment from Fig. 5 for the amplifier and the loudspeaker to be switched off for low frequencies on the basis of the energy saving mode M_{S} and/or the threshold frequency f_{G}. It is acoustically advantageous here for the cut-off frequency f_{G} of the filter 125 to be modified slowly over time, for example by means of a timer and/or as a function of the change state C over time of the rechargeable battery 2.

The embodiment from Fig. 5b makes it possible to select from among low-power music titles. The control unit 120 of the exemplary embodiment from Fig. 5b has an analysis unit 122 and a selection unit 126. Preferably, the energy content of each music title in the database 130 is determined and an associated energy value E is stored in the database 130 with the metadata of the applicable music piece. For example, the energy content is categorized from 1 to 10 by means of a scale of the energy values. For example, E = 1 means very low power with a small bass portion B. This music title can be played when the rechargeable battery 2 is in critically low charge states C. The energy value E = 10 means very high power with a large bass portion B. This music title is not played in critical charge states C.

If the user is listening to content from his MP3 database 130, audio files A₁, A₂, A₃ of titles in the database 130 are permitted to be output or not as a function of the charge state C of the rechargeable battery 2 and, where applicable, as a function of the remaining travel distance. In the exemplary embodiment from Fig. 5b the decision regarding permissibility is made on the basis of an energy threshold th_{E}. For example, all audio files A₁, A₂, A₃ from the database 130 that have an energy value E lower than the energy threshold th_{E} are queried by means of a query Q(E). The threshold is th_{E} = 5, for example, so that only the second audio file A₂ and the third audio file A₃ are read out as per the exemplary embodiment in Fig. 4. The audio files A(Q) dependent on the query Q(E) that are output are looped through the control unit 120, optionally are additionally filtered, and are output as audio signal S_{A} with reduced bass portion B. The exemplary embodiments in Fig. 5a and Fig. 5b are combined with one another in a control unit 120 to good advantage.

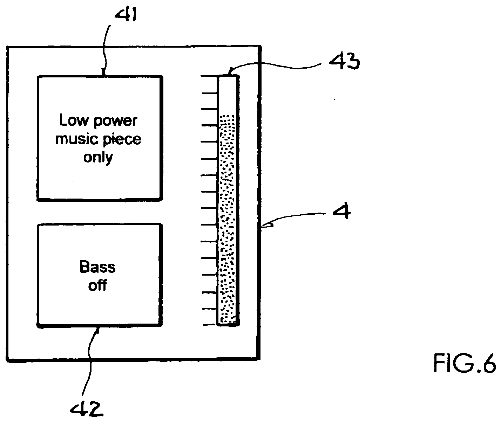

In Fig. 6 an input unit 4 is shown schematically as a touch screen. The touch screen 4 is shown with a graphical user interface with multiple widgets. A first icon 41 as input element permits the activation of a selection of only low power music pieces, which, for example, only have an energy value E below the energy threshold th_{E} in accordance with the exemplary embodiment from Fig. 2. A second icon 42 as input element permits the activation of filtering by a filter 125, which reduces the bass portion B. In addition, a consumption indicator 43 is shown as a widget, which symbolizes energy consumption in the form of a bar graph, for example. It is likewise possible for the widget 43 to have an input function, so that the user can specify the associated energy consumption directly by touching the bar 43 at a certain location.

In addition to the above-mentioned possibilities for reducing energy consumption, it is possible to reduce the loudness of the entire frequency spectrum X(f_{SA}) of the audio signal S_{A} in order to further reduce power consumption. Preferably, an upper loudness threshold is lowered when the charge state C of the rechargeable battery 2 drops. For example, the threshold loudness can be reduced proportionately to the charge state C. If the energy situation is very critical, audio reproduction can also be eliminated entirely, so that, for example, only predetermined audio content such as radio traffic reports, news, telephone, and navigational announcements are input as audio signal S_{A}. The measures for reducing energy consumption can be combined with one another in any desired way. The energy consumption is calculated as a function of the filter setting and/or the energy value E, and is fed to a central energy management system or the range information in an electric vehicle.

## Claims

1. Device (1) for reproducing an audio signal (S_{A}),
- with a first Interface (101) to connect an energy storage device (2),
- with a second interface (102) to connect a loudspeaker (3),
- with an amplifier (110) connectable to the second interface (102), wherein the amplifier (110) Is configured to amplify the audio signal (S_{A}), wherein the amplifier (110) is connectable to the energy storage device (2) for operation,
- with a control device (120), which is connected to the first interface (101) and to the amplifier (110),
- the control device (120) is configured to operate a normal mode (M_{N}) and an energy saving mode (M_{S}), wherein in the energy saving mode (M_{S}) power consumption from the energy storage device (2) for reproduction of the audio signal (S_{A}) is reduced as compared to the normal mode (M_{N}),
- the control device (120) is configured to reduce a bass frequency component (B) of a frequency spectrum (X(f_{SA})) of the audio signal (S_{A}) and to output the audio signal (S_{A}) with the reduced bass frequency component (B) in the energy saving mode (M_{S}),
- the control device (120) is configured to determine a charge state (C) of the energy storage device (2),
- the control device (120) is configured to control the reduction in the bass frequency component (B) based on a decrease In the charge state (C) of the energy storage device (2); **characterized in that**
the control device (120) is connected to a database (130) with stored audio files (A₁, A₂, A₃), an energy value (E_{1,} E₂, E₃) is stored for each of said audio files (A₁, A₂, A₃), wherein the energy value (E₁, E₂, E₃) is based on the bass frequency component (B) of a frequency spectrum (X(f_{A1}), X(f_{A2}), X(f_{A3})) of the respective one of said audio files (A₁, A₂, A₃),
the control device (120) is configured to determine an energy threshold (th_{E}) based on the charge state (C) of the energy storage device (2),
the control device (120) is configured, for the purpose of controlling the bass frequency component (B), to ascertain one of said audio files (A₁, A₂, A₃) to be output based on the associated energy value (E₁, E₂, E₃) of the one of said audio files (A₁, A₂, A₃) and based on the energy threshold (th_{E}), and to output the one of said audio files (A₁, A₂, A₃) as the audio signal (S_{A}).

2. Device (1) according to claim 1, wherein the control device (120) is configured to determine a current position and a route to a destination with a distance to the destination and to control the reduction in the bass frequency component (B) based on the charge state (C) and the determined distance to the destination.

3. Device (1) according to one of the preceding claims,
wherein
the control device (120) is configured to filter the audio signal to be output (S_{A}) through a digital or analog filter (125) to reduce the bass frequency component (B).

4. Device (1) according to claim 3,
wherein
the control device (120) is configured to determine a threshold frequency (f_{G1}, f_{G2}, f_{G3}, f_{G4}) of the filter (125) based on the charge state (C) of the energy storage device (2).

5. Device (1) according to one of the preceding claims,
wherein
the control device (120) is configured to activate the energy saving mode (M_{S}) based on an input through an input unit (4).

6. Method for controlling a reproduction of an audio signal (S_{A}) of a device powered by an energy storage device (2),
comprising
deactivating a normal mode (M_{N}) and activating an energy saving mode (M_{S}), wherein an power consumption from the energy storage device (2) for reproduction of the audio signal (S_{A}) is reduced in the energy saving mode (M_{S}) as compared to the normal mode (M_{N}),
in the energy saving mode (M_{S}) reducing a bass frequency component (B) of a frequency spectrum (X(f_{SA})) of the audio signal (S_{A}) and outputting the audio signal (S_{A}) with reduced bass frequency component (B),
ascertaining a charge state (C) of the energy storage device (2),
controlling the reduction in the bass frequency component (B) based on a decrease in the charge state (C) of the energy storage device (2);
**characterized by**
storing in a database (130) audio files (A₁, A₂, A₃) and an energy value (E₁, E₂, E₃) for each of said audio files (A₁, A₂, A₃), wherein the energy value (E₁, E₂, E₃) is based on the bass frequency component (B) of a frequency spectrum (X(f_{A1}), X(f_{A2}), X(f_{A3})) of the respective one of said audio files (A₁, A₂, A₃);
determining an energy threshold (th_{E}) based on the charge state (C) of the energy storage device (2);
controlling the bass frequency component (B), to ascertain one of said audio files (A₁, A₂, A₃) to be output based on the associated energy value (E₁, E₂, E₃) of the one of said audio files (A₁, A₂, A₃) and based on the energy threshold (th_{E}); and
outputting the one of said audio files (A₁, A₂, A₃) as the audio signal (S_{A}).

7. Method according to claim 6, further comprising determining a current position and a route to a destination with a distance to the destination and
the determined distance.

## Patentansprüche

1. Vorrichtung (1) zur Wiedergabe eines Audiosignals (S_{A}),
- mit einer ersten Schnittstelle (101) für das Verbinden einer Energiespeichervorrichtung (2)
- mit einer zweiten Schnittstelle (102) für das Verbinden eines Lautsprechers (3)
- mit einem Verstärker (110), der mit der zweiten Schnittstelle (102) verbunden werden kann, wobei der Verstärker (110) dazu konfiguriert ist, das Audiosignal (S_{A}) zu verstärken, wobei der Verstärker (110) für den Betrieb mit der Energiespeichervorrichtung (2) verbunden werden kann,
- mit einer Steuervorrichtung (120), die mit der ersten Schnittstelle (101) und mit dem Verstärker (110) verbunden ist,
- wobei die Steuervorrichtung (120) dazu konfiguriert ist, einen normalen Modus (M_{N}) und einen Energiesparmodus (Ms) zu betreiben, wobei im Energiesparmodus (M_{S}) die Leistungsaufnahme aus der Energiespeichervorrichtung (2) für die Wiedergabe des Audiosignals (S_{A}) im Vergleich zum normalen Modus (M_{N}) reduziert ist,
- wobei die Steuervorrichtung (120) dazu konfiguriert ist, eine Bassfrequenzkomponente (B) eines Frequenzspektrums (X(fs_{A})) des Audiosignals (S_{A}) zu reduzieren und im Energiesparmodus (Ms) das Audiosignal (S_{A}) mit der reduzierten Bassfrequenzkomponente (B) auszugeben,
- wobei die Steuervorrichtung (120) dazu konfiguriert ist, einen Ladezustand (C) der Energiespeichervorrichtung (2) zu ermitteln,
- wobei die Steuervorrichtung (120) dazu konfiguriert ist, das Reduzieren der Bassfrequenzkomponente (B) auf Grundlage einer Verringerung des Ladezustands (C) der Energiespeichervorrichtung (2) zu steuern;
**dadurch gekennzeichnet, dass**
die Steuervorrichtung (120) mit einer Datenbank (130) mit gespeicherten Audiodateien (A₁, A₂, A₃) verbunden ist,
für jede der Audiodateien (A₁, A₂, A₃) ein Energiewert (E₁, E₂, E₃) gespeichert ist, wobei der Energiewert (E₁, E₂, E₃) auf der Bassfrequenzkomponente (B) eines Frequenzspektrums (X(f_{A1}), X(f_{A2}), X(f_{A3})) der entsprechenden Audiodatei (A₁, A₂, A₃) beruht, die Steuervorrichtung (120) dazu konfiguriert ist, auf Grundlage des Ladezustands (C) der Energiespeichervorrichtung (2) einen Energieschwellenwert (th_{E}) zu ermitteln,
die Steuervorrichtung (120) dazu konfiguriert ist, zwecks Steuern der Bassfrequenzkomponente (B) eine der auszugebenden Audiodateien (A₁, A₂, A₃) auf Grundlage des zugeordneten Energiewerts (E₁, E₂, E₃) der jeweiligen Audiodatei (A₁, A₂, A₃) und auf Grundlage des Energieschwellenwerts (th_{E}) zu überprüfen und die eine der Audiodateien (A₁, A₂, A₃) als Audiosignal (S_{A}) auszugeben.

2. Vorrichtung (1) nach Anspruch 1, wobei die Steuervorrichtung (120) dazu konfiguriert ist, eine derzeitige Position und eine Route zu einem Ziel mit der Entfernung zum Ziel zu ermitteln und das Reduzieren der Bassfrequenzkomponente (B) auf Grundlage des Ladezustands (C) und der ermittelten Entfernung zum Ziel zu steuern.

3. Vorrichtung (1) nach einem der vorhergehenden Ansprüche, wobei
die Steuervorrichtung (120) dazu konfiguriert ist, das auszugebende Audiosignal (S_{A}) durch einen digitalen oder analogen Filter (125) zu filtern, um die Bassfrequenzkomponente (B) zu reduzieren.

4. Vorrichtung (1) nach Anspruch 3,
wobei
die Steuervorrichtung (120) dazu konfiguriert ist, eine Schwellenwertfrequenz (f_{G1}, f_{G2}, f_{G3}, f_{G4}) des Filters (125) auf Grundlage des Ladezustands (C) der Energiespeichervorrichtung (2) zu ermitteln.

5. Vorrichtung (1) nach einem der vorhergehenden Ansprüche, wobei
die Steuervorrichtung (120) dazu konfiguriert ist, den Energiesparmodus (Ms) auf Grundlage einer Eingabe durch eine Eingabeeinheit (4) zu aktivieren.

6. Verfahren zum Steuern einer Wiedergabe eines Audiosignals (S_{A}) einer von einer Energiespeichervorrichtung (2) angetriebenen Vorrichtung, wobei das Verfahren Folgendes umfasst:
Deaktivieren eines normalen Modus (M_{N}) und Aktivieren eines Energiesparmodus (Ms), wobei eine Leistungsaufnahme von der Energiespeichervorrichtung (2) zur Wiedergabe des Audiosignals (S_{A}) im Energiesparmodus (M_{S}) im Vergleich zum normalen Modus (M_{N}) reduziert ist,
Reduzieren einer Bassfrequenzkomponente (B) eines Frequenzspektrums (X(fs_{A})) des Audiosignals (S_{A}) und Ausgeben des Audiosignals (S_{A}) mit reduzierter Bassfrequenzkomponente (B) im Energiesparmodus (Ms),
Überprüfen eines Ladezustands (C) der Energiespeichervorrichtung (2),
Steuern des Reduzierens der Bassfrequenzkomponente (B) auf Grundlage einer Verringerung des Ladezustands (C) der Energiespeichervorrichtung (2);
**gekennzeichnet durch**
Speichern von Audiodateien (A₁, A₂, A₃) und eines Energiewerts (E₁, E₂, E₃) für die jeweilige Audiodatei (A₁, A₂, A₃) in einer Datenbank (130), wobei der Energiewert (E₁, E₂, E₃) auf der Bassfrequenzkomponente (B) eines Frequenzspektrums (X(f_{A1}), X(f_{A2}), X(f_{A3})) der entsprechenden Audiodatei (A₁, A₂, A₃) beruht;
Ermitteln eines Energieschwellenwerts (th_{E}) auf Grundlage des Ladezustands (C) der Energiespeichervorrichtung (2);
Steuern der Bassfrequenzkomponente (B) zum Überprüfen einer der auszugebenden Audiodateien (A₁, A₂, A₃) auf Grundlage des zugeordneten Energiewerts (E₁, E₂, E₃) der einen der Audiodateien (A₁, A₂, A₃) und auf Grundlage des Energieschwellenwerts (th_{E}); und
Ausgeben der einen der Audiodateien (A₁, A₂, A₃) als Audiosignal (S_{A}) .

7. Verfahren nach Anspruch 6, das ferner das Ermitteln einer derzeitigen Position und einer Route zu einem Ziel mit einer Entfernung zum Ziel und der ermittelten Entfernung umfasst.

## Revendications

1. Dispositif (1) de reproduction d'un signal audio (S_{A}),
- avec une première interface (101) pour se raccorder à un dispositif de stockage d'énergie (2),
- avec une seconde interface (102) pour se raccorder à un haut-parleur (3),
- avec un amplificateur (110) pouvant être raccordé à la seconde interface (102), dans lequel l'amplificateur (110) est configuré pour amplifier le signal audio (S_{A}), dans lequel l'amplificateur (110) peut être raccordé au dispositif de stockage d'énergie (2) pour fonctionner,
- avec un dispositif de régulation (120), qui est raccordé à la première interface (101) et à l'amplificateur (110),
- le dispositif de régulation (120) est configuré pour fonctionner en mode normal (M_{N}) et en mode économie d'énergie (M_{S}), dans lequel dans le mode économie d'énergie (M_{S}) une consommation d'alimentation provenant du dispositif de stockage d'énergie (2) pour la reproduction du signal audio (S_{A}) est réduite comparée au mode normal (M_{N}),
- le dispositif de régulation (120) est configuré pour réduire une composante de fréquence de basse (B) d'un spectre de fréquence (X(fs_{A})) du signal audio (S_{A}) et pour fournir en sortie le signal audio (S_{A}) avec la composante de fréquence de basse (B) réduite dans le mode économie d'énergie (M_{S}),
- le dispositif de régulation (120) est configuré pour déterminer un état de charge (C) du dispositif de stockage d'énergie (2),
- le dispositif de régulation (120) est configuré pour réguler la réduction de la composante de fréquence de basse (B) d'après une diminution de l'état de charge (C) du dispositif de stockage d'énergie (2) ;
**caractérisé en ce que**
le dispositif de régulation (120) est raccordé à une base de données (130) avec des fichiers audio stockés (A₁, A₂, A₃),
une valeur d'énergie (E₁, E₂, E₃) est stockée pour chacun desdits fichiers audio (A₁, A₂, A₃), dans lequel la valeur d'énergie (E₁, E₂, E₃) est basée sur la composante de fréquence de basse (B) d'un spectre de fréquence (X(f_{A1}) , X(f_{A2}), X(f_{A3})) du fichier respectif desdits fichiers audio (A₁, A₂, A₃),
le dispositif de régulation (120) est configuré pour déterminer un seuil d'énergie (th_{E}) d'après l'état de charge (C) du dispositif de stockage d'énergie (2),
le dispositif de régulation (120) est configuré, dans le but de réguler la composante de fréquence de basse (B), pour vérifier l'un desdits fichiers audio (A₁, A₂, A₃) à fournir en sortie d'après la valeur d'énergie (E₁, E₂, E₃) associée de l'un desdits fichiers audio (A₁, A₂, A₃) et d'après le seuil d'énergie (th_{E}), et pour fournir en sortie le fichier desdits fichiers audio (A₁, A₂, A₃) en tant que signal audio (S_{A}).

2. Dispositif (1) selon la revendication 1, dans lequel le dispositif de régulation (120) est configuré pour déterminer une position actuelle et un itinéraire jusqu'à une destination avec une distance jusqu'à la destination et pour réguler la réduction de la composante de fréquence de basse (B) d'après l'état de charge (C) et la distance jusqu'à la destination déterminée.

3. Dispositif (1) selon l'une des revendications précédentes, dans lequel
le dispositif de régulation (120) est configuré pour filtrer le signal audio à fournir en sortie (S_{A}) par l'intermédiaire d'un filtre numérique ou analogique (125) pour réduire la composante de fréquence de basse (B).

4. Dispositif (1) selon la revendication 3,
dans lequel
le dispositif de régulation (120) est configuré pour déterminer une fréquence seuil (f_{G1}, f_{G2}, f_{G3}, f_{G4}) du filtre (125) d'après l'état de charge (C) du dispositif de stockage d'énergie (2).

5. Dispositif (1) selon l'une des revendications précédentes, dans lequel
le dispositif de régulation (120) est configuré pour activer le mode économie d'énergie (Ms) d'après une entrée par l'intermédiaire d'une unité d'entrée (4).

6. Procédé de régulation d'une reproduction d'un signal audio (S_{A}) d'un dispositif alimenté par un dispositif de stockage d'énergie (2),
comprenant
la désactivation d'un mode normal (M_{N}) et l'activation d'un mode économie d'énergie (M_{S}), dans lequel une consommation d'alimentation provenant du dispositif de stockage d'énergie (2) pour la reproduction du signal audio (S_{A}) est réduite dans le mode économie d'énergie (M_{S}) comparé au mode normal (M_{N}),
dans le mode économie d'énergie (Ms), la réduction d'une composante de fréquence de basse (B) d'un spectre de fréquence (X(fs_{A})) du signal audio (S_{A}) et la fourniture en sortie du signal audio (S_{A}) avec une composante de fréquence de basse (B) réduite,
la vérification d'un état de charge (C) du dispositif de stockage d'énergie (2),
la régulation de la réduction de la composante de fréquence de basse (B) d'après une diminution de l'état de charge (C) du dispositif de stockage d'énergie (2) ;
**caractérisé par**
le stockage dans une base de données (130) de fichiers audio (A₁, A₂, A₃) et d'une valeur d'énergie (E₁, E₂, E₃) pour chacun desdits fichiers audio (A₁, A₂, A₃), dans lequel la valeur d'énergie (E₁, E₂, E₃) est basée sur la composante de fréquence de basse (B) d'un spectre de fréquence (X(f_{A1}), X(f_{A2}), X(fA₃)) du fichier respectif desdits fichiers audio (A₁, A₂, A₃) ;
la détermination d'un seuil d'énergie (th_{E}) d'après l'état de charge (C) du dispositif de stockage d'énergie (2) ;
la régulation de la composante de fréquence de basse (B), pour vérifier l'un desdits fichiers audio (A₁, A₂, A₃) à fournir en sortie d'après la valeur d'énergie (E₁, E₂, E₃) associée du fichier desdits fichiers audio (A₁, A₂, A₃) et d'après le seuil d'énergie (th_{E}) ; et
la fourniture en sortie du fichier desdits fichiers audio (A₁, A₂, A₃) en tant que signal audio (S_{A}).

7. Procédé selon la revendication 6, comprenant en outre la détermination d'une position actuelle et d'un itinéraire jusqu'à une destination avec une distance jusqu'à la destination et de la distance déterminée.
